Europäisches Patentamt

European Patent Office

Office européen des brevets

(19)

(11) Numéro de publication: **0 0 1 0 0 1 4**
**B1**

(12) FASCICULE DE BREVET EUROPEEN

(45) Date de publication du fascicule du brevet:
**20.07.83**

(21) Numéro de dépôt: **79400612.2**

(22) Date de dépôt: **04.09.79**

(51) Int. Cl.³: **H 03 H 15/02,** H 03 H 19/00,
H 01 L 27/10, H 03 F 3/70

(54) **Filtre à transfert de charges et filtre à capacités commutées comportant un multiplicateur de tension à capacités commutées.**

(30) Priorité: **26.09.78 FR 7827505**

(43) Date de publication de la demande:
**16.04.80 Bulletin 80/8**

(45) Mention de la délivrance du brevet:
**20.07.83 Bulletin 83/29**

(84) Etats contractants désignés:
**DE GB NL**

(56) Documents cités:
NACHRICHTENTECHNIK-ELEKTRONIK, vol. 27, no. 2, 1977, Berlin (DE) H. UNGER: «*Analoge rekursive Abtastfilter auf der Basis von Eimerkettenschaltungen*», pages 79–82

«High voltage physics» by L. Jacob Methuen and Co 1934, pages 6, 7, 8

(73) Titulaire: **THOMSON-CSF, 173, Boulevard Haussmann, F-75379 Paris Cedex 08 (FR)**

(72) Inventeur: **Benoit-Gonin, Roger, "THOMSON-CSF" - SCPI 173, bld Haussmann, F-75360 Paris Cedex 08 (FR)**
Inventeur: **Berger, Jean-Luc, "THOMSON-CSF" - SCPI 173, bld Haussmann, F-75360 Paris Cedex 08 (FR)**
Inventeur: **Coutures, Jean-Louis, "THOMSON-CSF" - SCPI 173, bld Haussmann, F-75360 Paris Cedex 08 (FR)**
Inventeur: **Forster, Daniel, "THOMSON-CSF" - SCPI 173, bld Haussmann, F-75360 Paris Cedex 08 (FR)**
Inventeur: **Picquendar, Jean-Edgar, "THOMSON-CSF" - SCPI 173, bld Haussmann, F-75360 Paris Cedex 08 (FR)**

(74) Mandataire: **Benichou, Robert et al, THOMSON-CSF SCPI 173 bld Haussmann, F-75379 Paris Cedex 08 (FR)**

ACTORUM AG

## Filtre à transfert de charges et filtre à capacités commutées comportant un multiplicateur de tension à capacités commutées

La présente invention concerne les filtres à transfert de charges et les filtres à capacités commutées comportant un multiplicateur de tension à capacités commutées.

Les filtres à capacités commutées ont été décrits, en particulier, dans deux articles de la revue américaine «Proceedings of the Institute of Electrical and Electronics Engineers»: volume SC 12, no 6, décembre 1977, pages 592 à 608 et «International symposium on circuits and systems proceedings», avril 1977, pages 525 à 529.

Les filtres à capacités commutées se composent essentiellement d'une cellule de filtrage et d'un amplificateur. La cellule de filtrage, qui est intégrée, a les mêmes propriétés qu'une cellule de filtrage classique, constituée de résistances et de capacités, mais elle ne comporte que des capacités et des transistors MOS. Les résistances sont remplacées par une combinaison de transistors MOS et de capacités, ce qui permet notamment de diminuer leur encombrement et d'obtenir une plus grande stabilité en température et une meilleure linéarité. L'amplificateur, associé à la cellule de filtrage, doit avoir un gain très stable et bien défini. Un amplificateur opérationnel est généralement utilisé.

Le problème que notre invention cherche à résoudre est le suivant. Dans les filtres à capacités commutées, on utilise un amplificateur opérationnel. Or, il est très difficile d'intégrer cet amplificateur opérationnel sur le même substrat que la cellule de filtrage, car il est encombrant et sa consommation est élevée.

Le même problème se pose avec les filtres à transfert de charges qui utilisent un amplificateur différentiel.

Selon l'invention, on remplace l'amplificateur par un multiplicateur de tension qui utilise la même technologie que la cellule de filtrage puisqu'il se compose uniquement de capacités et de transistors MOS, il peut donc être facilement intégré avec celle-ci. Ce multiplicateur présente également l'avantage d'un gain très stable, bien défini, et d'une faible consommation.

On connaît par l'ouvrage intitulé «High voltage physics» de L. Jacob, Methuen, 1934, pages 6, 7 et 8, un multiplicateur de tension constitué par des capacités commutées périodiquement de parallèle en série, et vice-versa, à l'aide de redresseurs à tubes (thermionic rectifiers).

La présente invention concerne un filtre à transfert de charges et un filtre à capacités commutées qui comportent, à la place d'un amplificateur, un multiplicateur de tension constitué de n capacités, périodiquement commutées en parallèle et une série, par des transistors du type MOS fonctionnant en commutation. Une même tension charge simultanément les n capacités commutées en parallèle et une tension amplifiée est obtenue entre les bornes extrêmes des n capacités commutées en série. De plus, les n capacités et les transistors MOS sont intégrés sur le même substrat semi-conducteur.

D'autres objets, caractéristiques et résultats de l'invention ressortiront de la description suivante, donnée à titre d'exemple non limitatif et illustrée par les figures annexées qui représentent:
- la fig. 1, un mode de réalisation d'un multiplicateur de tension à capacités commutées;
- les figs 2a, b, c, d, des diagrammes des phases de signaux appliqués à ce multiplicateur;
- la fig. 3, un mode de réalisation d'un multiplicateur différentiel à capacités commutées;
- les figs 4a et 4b, respectivement, une vue en coupe d'une capacité intégrée et le schéma électrique qui lui est équivalent;
- la fig. 5, un autre mode de réalisation d'un multiplicateur différentiel à capacités commutées;
- les figs 6a et 6b, un mode de réalisation d'un filtre à capacités commutées selon l'invention comportant un multiplicateur à capacités commutées;
- la fig. 7, un mode de réalisation d'un filtre à transfert de charges selon l'invention comportant un multiplicateur différentiel à capacités commutées.

Sur les différentes figures, les mêmes repères désignent les mêmes éléments et pour des raisons de clarté, les cotes et proportions des différents éléments n'ont pas été respectées.

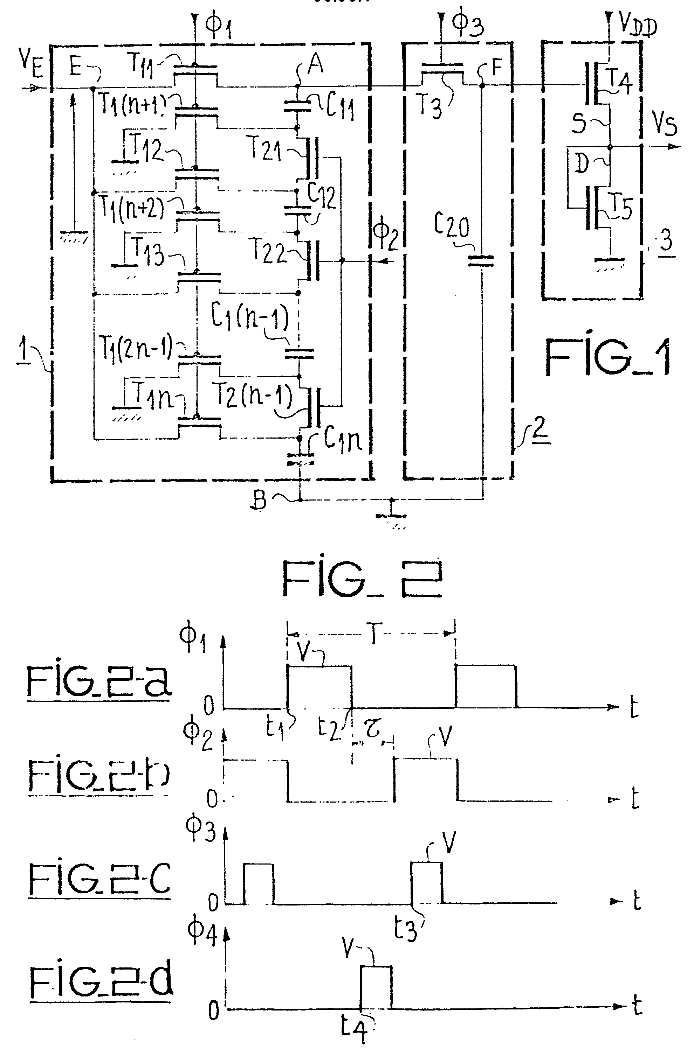

Sur la fig. 1 est représenté un mode de réalisation d'un multiplicateur de tension à capacités commutées.

Soit $C_{11}$, $C_{12}$ ... $C_{1n}$ les n capacités à commuter périodiquement de parallèle en série et vice-versa:
- (n−1) transistors MOS, également appelés TMOS, $T_{21}$ à $T_2$ (n−1) sont connectés par leur drain et leur source entre les bornes de deux capacités successives, seules deux bornes sont laissées libres: la borne A de la capacité $C_{11}$ et la borne B de la capacité $C_{1n}$;
- n transistors MOS, $T_{11}$ à $T_{1n}$ sont connectés par leur drain et leur source entre l'une des bornes de chaque capacité, parmi lesquelles la borne extrême A, et l'entrée E où est appliquée une tension $V_E$.

(n−1) transistors MOS, $T_{1(n+1)}$ à $T_{1(2n−1)}$ sont connectés par leur drain et leur source entre l'autre borne de chaque capacité et la masse, excepté la borne B qui est reliée directement à la masse.

Les transistors MOS sont commandés par deux signaux périodiques $\Phi_1$ et $\Phi_2$ appliqués, respectivement, aux grilles des transistors $T_{11}$ à $T_{1(2n−1)}$, appartenant à un premier groupe de transistors $G_1$ et $T_{21}$ à $T_{2(n−1)}$, appartenant à un deuxième groupe de transistors $G_2$.

Les figs 2a et 2b représentent les diagrammes des phases des signaux périodiques $\Phi_1$ et $\Phi_2$.

Les diagrammes a et b représentent les potentiels $\Phi_1$ et $\Phi_2$, sensiblement en créneaux, dont l'amplitude, en volts, passe de O à V avec une période T. Les potentiels $\Phi_1$ et $\Phi_2$ ne sont jamais simultanément à V.

Le passage de $\Phi_1$ de V à O est séparé du passage de $\Phi_2$ de O à V par un intervalle de temps $\tau$ non nul.

Le fonctionnement du dispositif décrit précédemment, encadré en trait discontinu sur la fig. 1 et repéré par 1, est le suivant:

- au temps $t_1$, le signal $\Phi_1$ prend la valeur V qui rend conducteurs les TMOS $T_{11}$ à $T_{1(2n-1)}$. La tension $V_E$ charge alors les n capacités, en parallèle, à travers les TMOS $T_{11}$ à $T_{1n}$. Une borne de ces capacités est maintenue au potentiel de référence grâce aux TMOS $T_{1(n+1)}$ à $T_{1(2n-1)}$;
- au temps $t_2$, le signal $\Phi_1$ prend la valeur O qui bloque les TMOS du premier groupe, les n capacités sont alors chargées à la tension $V_E$;
- après un intervalle de temps $\tau$ non nul, pour que les TMOS des deux groupes ne soient pas simultanément conducteurs, le signal $\Phi_2$ passe à V et rend conducteurs les TMOS $T_{21}$ à $T_{2(n-1)}$. Les n capacités sont alors en série et la tension entre le point A et la masse est n × $V_E$.

Le premier groupe de TMOS assure donc la commutation en parallèle des n capacités et le deuxième groupe de TMOS leur commutation en série.

Un TMOS $T_3$ est connecté par son drain et sa source entre la borne extrême A et un point F. Une capacité $C_{20}$ est connectée entre le point F et le potentiel auquel est porté le point B, lorsque les capacités sont en série, qui est, dans ce cas, la masse.

Le TMOS $T_3$ est commandé par un signal périodique $\Phi_3$, appliqué à sa grille. Le potentiel $\Phi_3$, représenté sur la fig. 2c, est, comme $\Phi_1$ et $\Phi_2$, sensiblement en créneaux et passe de O à V avec une période T. Le potentiel $\Phi_3$ passe à V pendant l'intervalle de temps où le potentiel $\Phi_2$ se trouve à V. Le potentiel $\Phi_3$ peut être confondu avec $\Phi_2$.

Le dispositif précédemment décrit est encadré en trait discontinu sur la fig. 1 et repéré par 2.

Au temps $t_3$, lorsque le potentiel $\Phi_3$ passe à V, le TMOS $T_3$ conduit et la tension n × $V_E$ est transmise du point A au point F. La capacité $C_{20}$ permet un ajustage du gain de l'amplificateur et un maintien de l'information.

La tension en F, au temps $t_3$, est donnée en écrivant la conservation de la charge sur les capacités entre $t_2 + \tau$ et $t_3$ et dans le cas où les n capacités ont la même valeur C, par:

$$V_F = V_E \cdot \frac{n}{1 + n\dfrac{C_{20}}{C}}$$

Un étage de sortie permettant d'obtenir la tension amplifiée sur impédance moyenne est reliée au point F. Sur la fig. 1, cet étage est encadré en trait discontinu et repéré par 3.

Sur la fig. 1, l'étage de sortie est, par exemple, constitué par un étage suiveur comportant deux TMOS $T_4$ et $T_5$ en série. L'entrée sur l'étage suiveur se fait par la grille de $T_4$, le drain de $T_4$ étant alimenté par une tension $V_{DD}$ et la sortie se fait sur la source de $T_4$ à laquelle sont reliés la grille et le drain de $T_5$, la source de $T_5$ étant à la masse.

Le gain de l'étage suiveur s'écrit:

$$G_s = \frac{1}{1 + \sqrt{\dfrac{(W/L)5}{(W/L)4}}}$$

(W/L) 5,4 étant le rapport largeur sur longueur du canal MOS des TMOS $T_5$ et $T_4$.

Le gain global de l'amplificateur est donc:

$$g = \frac{n}{1 + \dfrac{n\,C_{20}}{C}} \cdot \frac{1}{1 + \sqrt{\dfrac{(W/L)5}{(W/L)4}}}$$

Ce gain est donc ajustable de façon continue par variation de $C_{20}$. Il est maximal lorsque la capacité $C_{20}$ se réduit à la capacité de grille du TMOS $T_4$. Il dépend du rapport des capacités $C_{20}/C$, de la géométrie des TMOS $T_4$ et $T_5$ et du nombre de capacités.

L'étage de sortie peut être relié directement en A. Le TMOS $T_3$ est donc supprimé. Dans ce cas, le gain est maximal. La capacité $C_{20}$ peut être toutefois conservée entre A et le point B pour ajuster le gain. Le TMOS $T_{11}$ charge alors, de $t_1$ à $t_2$, $C_{11}$ et $C_{20}$ en parallèle. L'expression de la tension en A, sans le TMOS $T_3$ et avec $C_{20}$ s'écrit:

$$V_A = V_E \cdot \frac{n\left(1 + \dfrac{C_{20}}{C}\right)}{1 + n\dfrac{C_{20}}{C}}$$

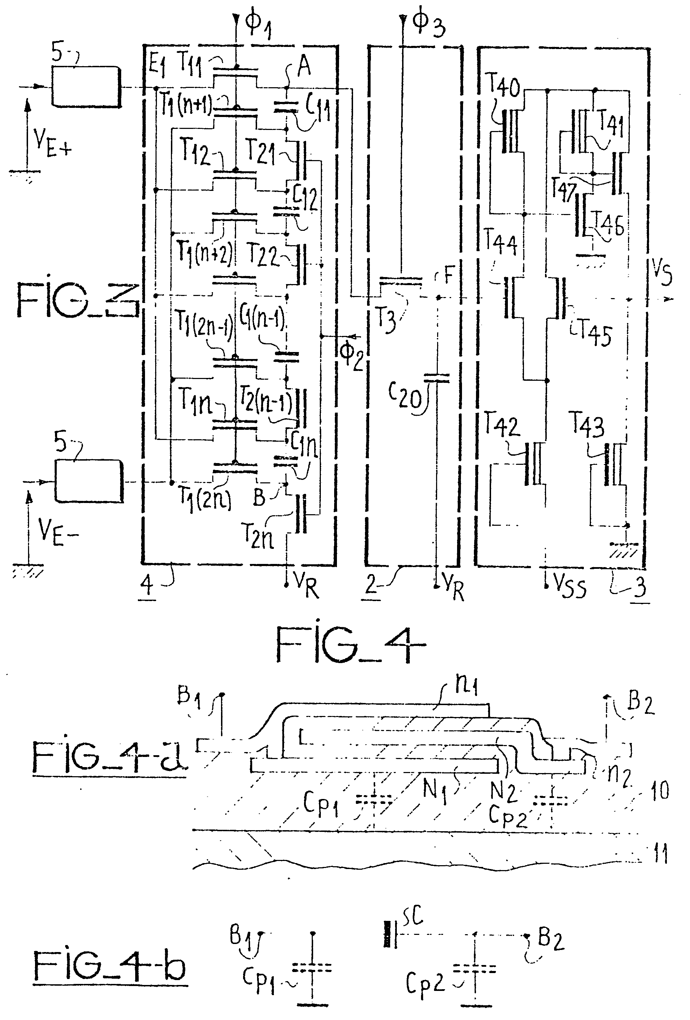

La fig. 3 représente un mode de réalisation d'un multiplicateur différentiel à capacités commutées.

Comme sur la fig. 1, (n−1) TMOS $T_{21}$ à $T_2(n-1)$ sont connectées par leur drain et leur source entre les bornes de deux capacités successives, excepté les bornes extrêmes A et B. Un $n^{ième}$ TMOS $T_{2n}$ est dans ce cas connecté entre la borne B et une tension de référence $V_R$ qui peut être la masse.

Comme sur la fig. 1, n TMOS, $T_{11}$ à $T_{1n}$ sont connectés par leur drain et leur source entre l'une des bornes de chaque capacité, parmi lesquelles la borne extrême A, et une entrée $E_1$ où est appliquée une tension $V_E+$.

Dans ce cas, n TMOS $T_{1(n+1)}$ à $T_{1(2n)}$ sont connectés par leur drain et leur source entre l'autre borne de chaque capacité, parmi lesquelles la borne extrême B et une seconde entrée $E_2$, où est appliquée une tension $V_E^-$.

Les TMOS $T_{11}$ à $T_{1(2n)}$ et les TMOS $T_{21}$ à $T_{2n}$ sont commandés par des signaux périodiques $\Phi_1$ et $\Phi_2$, identiques à ceux représentés sur les figs 2a et b.

Le dispositif précédemment décrit est encadré en trait discontinu sur la fig. 3 et repéré par 4.

De $t_1$ à $t_2$, les n capacités en parallèle se chargent, non plus à la valeur $V_E$, mais à $V_E+ - V_E-$.

Au temps $t_2 + \tau$, la tension en A égale n $(V_E^+ - V_E^-) - V_R$ car le TMOS $T_{2n}$ relie le point B à une tension de référence $V_R$.

Au point A, on peut connecter un bloc identique à celui repéré par 2 sur la fig. 1, qui comprend un TMOS $T_3$ entre A et F, et une capacité $C_{20}$ entre F et la tension à laquelle est portée le point B lorsque les capacités sont en série, qui est dans ce cas $V_R$.

La tension en F, $V_F$, au temps $t_3$ est donnée en écrivant la conservation de la charge des capacités par:

$$V_F = \frac{n\,(V_{E^+} - V_{E^-})}{1 + n\,\dfrac{C_{20}}{C}} + \frac{V_R\,n\,\dfrac{C_{20}}{C}}{1 + n\,\dfrac{C_{20}}{C}}$$

Le premier terme de l'expression de $V_F$ est donc similaire à l'expression de $V_F$ pour le multiplicateur représenté sur la fig. 1. Le deuxième terme permet de régler la tension d'offset.

Un étage de sortie permettant d'obtenir la tension multipliée sur impédance moyenne peut être relié au point F ou directement au point A.

L'étage de sortie peut être un étage suiveur analogue à celui représenté sur la fig. 1, ce peut être aussi un circuit de gain unité classique comme celui représenté sur la fig. 3, qui comporte des TMOS à déplétion $T_{40}$, $T_{41}$, $T_{42}$, $T_{43}$ et à enrichissement $T_{44}$, $T_{45}$, $T_{46}$, $T_{47}$. La stabilité en température est encore accrue, mais il y a accroissement de la surface et de la puissance dissipées.

Les entrées du multiplicateur aussi bien dans le cas de la fig. 1 que dans la fig. 3 ne sont pas rigoureusement à haute impédance puisqu'il faut charger les n capacités en parallèle de $t_1$ à $t_2$. En général, la valeur des capacités est faible car on doit les intégrer sur le même substrat que les TMOS. Un étage d'entrée qui peut être un étage suiveur, analogue à celui repéré par 3 sur la fig. 1, peut être placé en amont de chaque entrée de l'amplificateur pour obtenir une entrée à très haute impédance. Ces étages suiveurs sont symbolisés par des rectangles repérés par 5 sur la fig. 3.

Sur les figs 4a et b sont représentés une vue en coupe d'une capacité intégrée et le schéma électrique qui lui est associé.

La capacité est réalisée dans une technologie à deux niveaux $N_1$ et $N_2$ de silicium polycristallin et, à un niveau d'aluminium, séparé en deux parties $n_1$ et $n_2$ isolées par de l'oxyde 10.

Une armature de la capacité reliée à la borne $B_1$ est réalisée par l'ensemble silicium $N_1$ et aluminium $n_1$, l'autre armature reliée à la borne $B_2$ est réalisée par l'ensemble silicium $N_2$ et aluminium $n_2$.

Les couches d'oxyde séparant les différentes métallisations sont minces par rapport à la couche d'oxyde 10 les séparant du substrat. La présence du substrat semi-conducteur 11, portant la couche d'oxyde, et qui est pris généralement comme référence des potentiels, introduit des capacités parasites $Cp_1$ et $Cp_2$ non négligeables sur les bornes $B_1$ et $B_2$ de la capacité C et représentées en pointillés sur la fig. 4a.

Les valeurs de $Cp_1$ et $Cp_2$ sont différentes: la valeur $C_{P1}$ est proportionnelle à la valeur de la capacité C réalisée, la valeur $C_{P2}$ est fixe et en général très inférieure à $C_{P1}$. On a représenté en trait épais, sur la fig. 4b, l'armature de la capacité C reliée à la borne $B_1$, et en trait mince l'armature de la capacité C reliée à la borne $B_2$.

Les capacités parasites sont particulièrement gênantes dans les amplificateurs différentiels à capacités commutées car elles introduisent en plus d'une diminution du gain, une augmentation importante du mode commun.

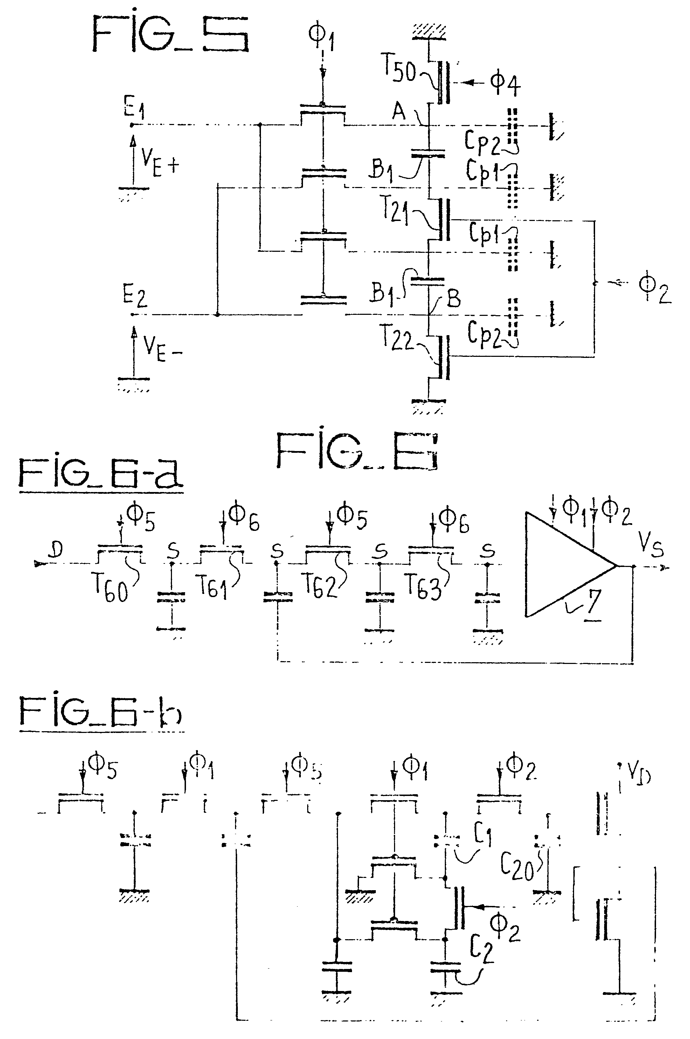

Sur la fig. 5 est représenté un mode de réalisation d'un amplificateur différentiel à deux capacités commutées, pour lequel la diminution de gain est réduite et le mode commun dû aux capacités parasites supprimé.

Sur cette fig., comme cela avait été fait sur la fig. 4b, les armatures de chaque capacité ont été représentées en trait épais et en trait mince, et les capacités parasites associées aux deux capacités à commuter sont représentées en pointillés; les deux capacités ont la même valeur C et leurs capacités parasites $C_{P1}$ et $C_{P2}$ sont donc les mêmes.

Ce mode de réalisation diffère de celui représenté sur la fig. 3 car:
- le TMOS $T_{21}$ du deuxième groupe a son drain et sa source obligatoirement reliés à deux bornes de même nom, $B_1$ ou $B_2$;
- un TMOS $T_{50}$ est connecté entre la borne extrême A et la masse et commandé par un signal périodique $\Phi_4$, appliqué à sa grille;
- la tension de référence $V_R$ est la masse.

Le signal $\Phi_4$ représenté sur la fig. 2d varie, comme $\Phi_1$, $\Phi_2$, $\Phi_3$, sensiblement en créneaux et passe de O à V en volts avec une période T. Le signal $\Phi_4$ passe à la valeur V entre $t_2$ et $t_2 + \tau$ alors que les deux capacités sont isolées les unes des autres.

Au temps $t_1$, les deux capacités C se chargent à $V_E^+ - V_E^-$, les capacités parasites $C_{P1}$ et $C_{P2}$ se chargent à $V_E^+$ ou à $V_E^-$ selon que la borne où elles apparaissent est reliée à $E_1$ ou $E_2$;

Au temps $t_4$, le signal $\Phi_4$ passe à V et rend conducteur le TMOS $T_{50}$, la capacité parasite de la borne de la capacité $C_1$ reliée en A est déchargée, le signal $\Phi_4$ revient à O avant $t_2 + \tau$.

Au temps $t_2 + \tau$, les deux capacités sont mises en série, la capacité parasite de la borne de la capacité C reliée au point B est ainsi déchargée par $T_{22}$.

La tension en A au temps $t_3$ est, dans ce mode de réalisation, proportionnelle à $V_E^+ - V_E^-$

$$V_A = K \cdot [V_{E^-} - V_{E^-}]$$

Si la capacité parasite en A est très petite devant C, c'est généralement le cas pour $C_{P2}$, $V_A$ s'écrit:

$$V_A = \frac{2 + \alpha}{1 + 2\alpha} \cdot [V_{E^-} - V_{E^-}] \quad \text{avec } \alpha = \frac{Cp}{C},$$

$C_p$ est capacité parasite des capacités C autre que la capacité parasite en A.

Les étages reliés au point A et avant les entrées $E_1$ et $E_2$ sont les mêmes que ceux utilisés dans le cas d'un amplificateur différentiel tel que celui de la fig. 3.

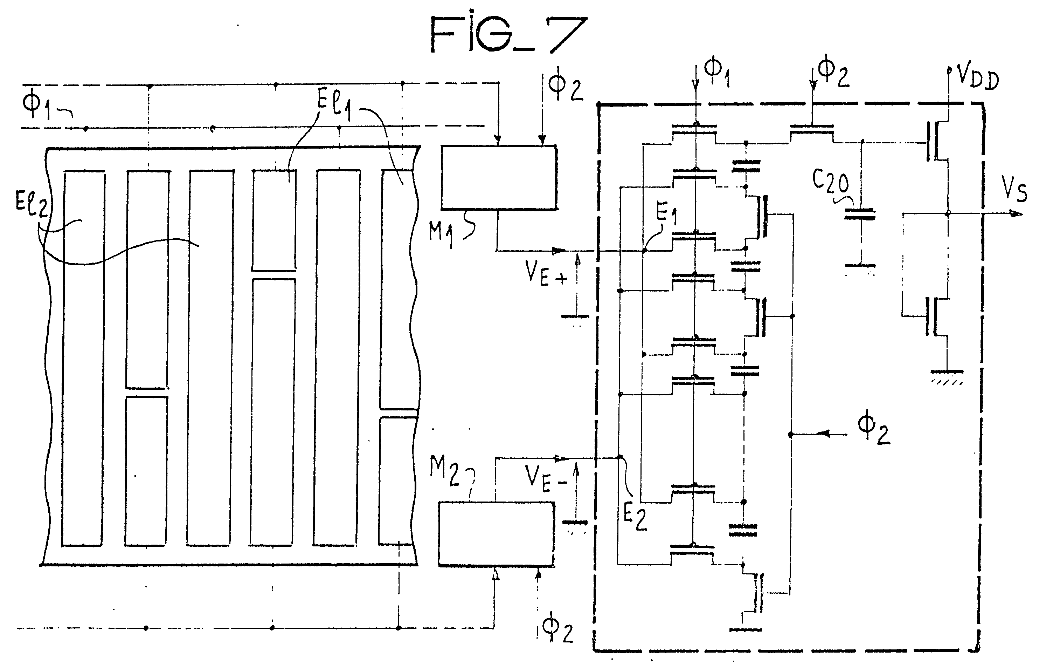

Les figs 6a et 6b représentent un filtre à capacités commutées selon l'invention comportant un multiplicateur à capacités commutées.

Sur ces figures, un filtre du type passe-bas est pris comme exemple.

Sur la fig. 6a, ce filtre est réalisé par la mise en série d'une cellule de filtrage à capacités commutées, et d'un multiplicateur à capacités commutées à entrée unique, représenté symboliquement et repéré par 7, la sortie du multiplicateur étant bouclée sur la cellule. Le gain du multiplicateur doit être compris entre 1 et 2, ce qui limite à deux le nombre de capacités à commuter. La cellule de filtrage comporte quatre TMOS en série, $T_{60}$, $T_{61}$, $T_{62}$, $T_{63}$, l'entrée se fait sur le drain de $T_{60}$ et la sortie sur la source de $T_{63}$, une capacité est reliée entre la source de $T_{60}$, $T_{62}$, $T_{63}$ et la masse et entre la source de $T_{61}$ et la sortie du multiplicateur. Quatre signaux périodiques au moins sont nécessaires au fonctionnement, deux pour la cellule de filtrage $\Phi_5$ et $\Phi_6$ et deux pour le multiplicateur $\Phi_1$ et $\Phi_2$.

Sur la fig. 6b est représenté un schéma du filtre de la fig. 6a, dans lequel la dernière capacité de la cellule est confondue avec les deux capacités, $C_1$ et $C_2$, à commuter du multiplicateur. Trois signaux périodiques seulement sont alors nécessaires.

Ce filtre du second ordre réalisé entièrement à l'aide de capacités commutées peut être comme cellule de pré- et post-filtrage d'un filtre transversal à transfert de charge. Il peut être alors commandé par les mêmes signaux périodiques que le circuit à transfert de charges.

Sur la fig. 7 est représenté un filtre à transfert de charges selon l'invention utilisant un multiplicateur à capacités commutées.

Un filtre à transfert de charges comporte:
- un substrat semi-conducteur;
- une couche isolante déposée sur le substrat;
- des électrodes déposées sur la couche isolante alternativement coupées en deux parties $EI_1$ et non coupées $EI_2$, qui assurent sur application de potentiels donnés le transfert des charges dans le semi-conducteur;
- des moyens de lecture, $M_1$ et $M_2$, des quantités de charges présentes sous les deux parties des électrodes coupées. De tels moyens sont connus dans l'art antérieur;
- un amplificateur différentiel réalisé sur le même substrat semi-conducteur que le reste du filtre, qui reçoit sur ses deux entrées, $E_1$ et $E_2$, les tensions $V_E+$ et $V_E-$ fournies par les moyens de lecture et permettant d'élaborer la tension de sortie $V_s$ du filtre.

Sur la fig. 7, l'amplificateur différentiel est constitué par un multiplicateur différentiel à capacités commutées. Les signaux périodiques $\Phi_1$, $\Phi_2$, $\Phi_3$ peuvent être confondus avec des signaux utilisés dans le fonctionnement du dispositif à transfert de charges. Le multiplicateur à capacités commutées est bien adapté à ce genre d'application car il traite des signaux échantillonnés et ce sont des signaux échantillonnés que parviennent des moyens de lecture. L'intégration complète d'un filtre à transfert de charges peut être ainsi réalisée.

## Revendications

1. Filtre à transfert de charges comportant:
- un substrat semi-conducteur;
- une couche isolante déposée sur le substrat;
- des électrodes ($EI_1$, $EI_2$) déposées sur la couche isolante qui assurent sur application de potentiels donnés ($\Phi_1$, $\Phi_2$) le transfert des charges dans le substrat;
- des moyens de lecture ($M_1$, $M_2$) de quantités de charges;
- un amplificateur différentiel qui reçoit les tensions ($V_E^+$, $V_E^-$) fournies par les moyens de lecture et élabore la tension de sortie ($V_S$) du filtre;
caractérisé en ce que cet amplificateur est constitué par un multiplicateur de tension, comportant n capacités ($C_1$ à $C_n$), périodiquement commutées en parallèle et en série, par des transistors du type MOS ($T_{11}$ à $T_{2n}$) fonctionnant en commutation, une même tension chargeant simultanément les n capacités commutées en parallèle et une tension multipliée étant obtenue entre les bornes extrêmes (A et B), des n capacités commutées en série, et en ce que les n capacités et les transistors MOS sont intégrés sur le même substrat semi-conducteur.

2. Filtre à capacités commutées comportant au moins une cellule de filtrage constituée de capacités et de transistors MOS ($T_{60}$ à $T_{63}$) associée à un amplificateur (7), caractérisé en ce que cet amplificateur est constitué par un multiplicateur de tension, comportant n capacités ($C_1$ à $C_n$), périodiquement commutées en parallèle et en série, par des transistors du type MOS ($T_{11}$ à $T_{2(n-1)}$ fonctionnant en commutation, une même tension chargeant simultanément les n capacités commutées en parallèle et une tension multipliée étant obtenue entre les bornes extrêmes (A et B) des n capacités commutées en série, et en ce que les n capacités et les transistors MOS sont intégrés sur le même substrat semi-conducteur.

3. Filtre selon l'une des revendications 1 ou 2, caractérisé en ce que, dans le multiplicateur de tension, un premier groupe de transistors ($G_1$) assure la commutation en parallèle des n capacités et un deuxième groupe de transistors ($G_2$) assure la commutation en série de ces capacités, et en ce que la commutation des deux groupes de transistors est commandée par deux signaux périodiques ($\Phi_1$ et $\Phi_2$), appliqués aux grilles des transistors MOS, ces signaux étant tels que les deux groupes de transistors ne soient pas simultanément conducteurs.

4. Filtre selon les revendications 2 et 3, caractérisé en ce que n transistors du premier groupe,

$(T_{11}$ à $T_{1n})$, sont connectés, par leur drain et leur source, entre l'une des bornes de chaque capacité, parmi lesquelles l'une des bornes extrêmes (A), et l'entrée (E) où est appliquée une tension $(V_E)$, $(n-1)$ autres transistors du premier groupe, $(T_1 [n+1]$, à $T_1 [2n-1])$ étant connectés, par leur drain et leur source, entre l'autre borne de chaque capacité et la masse, excepté l'autre borne extrême (B) qui est reliée directement à la masse, $(n-1)$ transistors du deuxième groupe, $(T_{21}$ à $T_2 [n-1])$, étant connectés par leur drain et leur source entre les bornes de deux capacités, excepté les bornes extrêmes (A et B).

5. Filtre selon les revendications 1 et 3, caractérisé en ce que n transistors du premier groupe $(T_{11}$ à $T_{1n})$, sont connectés, par leur drain et leur source, entre l'une des bornes de chaque capacité, parmi lesquelles l'une des bornes extrêmes (A), et une entrée $(E_1)$ où est appliquée une tension $(V_E^+$, n autres transistors du premier groupe $(T_1 [n+1]$ à $T_1 [2n])$, étant connectés entre l'autre borne de chaque capacité, parmi lesquelles l'autre borne extrême (B), et une seconde entrée $(E_2)$ où est appliquée une autre tension $(V_E^-)$, $(n-1)$ transistors du deuxième groupe $(T_{21}$ à $T_2 [n-1]$ étant connectés, par leur drain et leur source entre les bornes de deux capacités, excepté les bornes extrêmes (A et B), et un $n^{\text{ième}}$ transistor du deuxième groupe $(T_{2n})$ étant connecté entre l'autre borne extrême (B) et une tension de référence $(V_R)$ permettant de régler la tension d'offset du multiplicateur ainsi rendu différentiel.

6. Filtre selon la revendication 5, caractérisé en ce qu'il comporte deux capacités à commuter, intégrées, qui ont la même valeur et présentent par rapport à leurs bornes $(B_1$ et $B_2)$ les mêmes capacités parasites $(C_{P1}$ et $C_{P2})$, les capacités parasites des deux bornes étant différentes, en ce qu'un transistor MOS du deuxième groupe $(T_{21})$ a son drain et sa source reliés aux deux bornes des deux capacités à commuter présentant la même capacité parasite, un autre transistor MOS $(T_{50})$ étant connecté par son drain et sa source entre l'une des bornes extrêmes (A) et la masse, ce transistor étant commandé par un signal $(\Phi_4)$ appliqué à sa grille, lui permettant de décharger la capacité parasite de la capacité reliée à cette borne extrême (A) dans l'intervalle de temps $(\tau)$ compris entre la fin de la mise en parallèle et la mise en série des capacités, et la tension de référence $(V_R)$ étant la masse du multiplicateur.

7. Filtre selon l'une des revendications 4, 5 ou 6, caractérisé en ce qu'un transistor MOS $(T_3)$ est connecté par son drain et sa source entre l'une des bornes extrêmes (A) et un point (F), et en ce qu'une capacité $(C_{20})$ est connectée d'une part à ce point (F) est d'autre part à la tension à laquelle est portée l'autre borne extrême (B) lorsque les capacités sont en série, ce transistor MOS $(T_3)$ fonctionnant en commutation et étant commandé par un signal périodique $(\Phi_3')$ appliqué à sa grille, ce transistor $(T_3)$ étant rendu conducteur pendant l'intervalle de temps où les capacités sont commutées en série pour permettre le transfert de la tension amplifiée de la borne extrême (A) vers ledit point (F) auxquels ce transistor est relié.

8. Filtre selon la revendication 4, caractérisé en ce qu'une capacité $(C_{20})$ est connectée entre les bornes extrêmes (A et B).

9. Filtre à capacités commutées selon la revendication 2, caractérisé en ce qu'il comporte deux capacités $(C_1, C_2)$, périodiquement commutées et en ce que le gain du multiplicateur est compris entre 1 et 2.

10. Filtre selon la revendication 9, caractérisé en ce que le multiplicateur à commutation de capacités comporte deux capacités à commuter $(C_1$ et $C_2)$ qui sont confondues avec la dernière capacité de la cellule de filtrage.

**Claims**

1. A charge transfer filter comprising
- a semiconductor substrate,
- an insulating layer coated on said substrate,
- electrodes $(El_1, El_2)$ placed on said insulating layer and ensuring by the application of given potentials $(\Phi_1, \Phi_2)$ the transfer of the charges in the substrate,
- reading means $(M_1, M_2)$ for reading the quantities of charges,
- a differential amplifier, which receives the voltages $(V_E^+, V_E^-)$ furnished by the reading means and which elaborates the output voltage $(V_S)$ of the filter,
characterized in that said amplifier is constituted by a voltage multiplier, comprising n capacities $(C_1$ to $C_n)$ which are switched periodically into a parallel and into a series configuration by means of MOS type transistors $(T_{11}$ to $T_{2n})$ operating as switches, one unique voltage charging simultaneously the n capacities when switched into a parallel configuration, and a multiplied voltage being obtained between the end terminals (A and B) of the series configuration of the n capacities, and characterized in that the n capacities and the MOS transistors are integrated on the same semiconductor substrate.

2. A filter of the switched capacities type comprising at least one filtering cell constituted of capacities and MOS transistors $(T_{60}$ to $T_{63})$ associated to an amplifier (7), characterized in that this amplifier is constituted by a voltage multiplier, comprising n capacities $(C_1$ to $C_n)$ which are switched periodically into a parallel and a series configuration by means of MOS type transistors $(T_{11}$ to $T_{2(n-1)})$ which operate as switches, one unique voltage charging simultaneously the n capacities when switched into a parallel configuration, and one multiplied voltage being obtained between the end terminals (A and B) of the n capacities when switched into a series configuration, and characterized in that the n capacities and the MOS transistors are integrated on the same semiconductor substrate.

3. A filter according to one of the claims 1 or 2, characterized in that in the voltage multiplier a first group of transistors $(G_1)$ ensures the switching into parallel of the n capacities, and a second

group of transistors ($G_2$) ensures the switching into series of these capacities, and characterized in that the switching of the two groups of transistors is commanded by two periodical signals ($\Phi_1$ and $\Phi_2$) which are applied to the grids of the MOS transistors and which are shaped so that the two groups are not conductive simultaneously.

4. A filter according to claims 2 and 3, characterized in that n transistors of the first group ($T_{11}$ to $T_{1n}$) are connected by their drain and their source between one of the terminals of each capacity, among which is one of the end terminals (A), and to the input (E), to which a voltage ($V_E$) is applied, (n–1) further transistors of the first group ($T_1[n+1]$ to $T_1[2n–1]$) being connected by their drain and their source between the other terminal of each capacity and earth, except the other end terminal (B), which is directly connected to earth, whereas (n–1) transistors of the second group ($T_{21}$ to $T_2[n–1]$) are connected by their drain and their source between the terminals of two capacities, except the end terminals (A and B).

5. A filter according to claims 1 and 3, characterized in that n transistors of the first group ($T_{11}$ to $T_{1n}$) are connected by their drain and their source between one of the terminals of each capacity, among which is one of the end terminals (A), and an input ($E_1$), to which a voltage ($V_E^+$) is applied, whereas n other transistors of the first group ($T_1[n+1]$ to $T_1[2n]$) are connected between the other terminal of each capacity, among which is the other end terminal (B), and a second input ($E_2$), to which another voltage ($V_E^-$) is applied, and whereas (n–1) transistors of the second group ($T_{21}$ to $T_{2(n-1)}$) are connected by their drain and their source between the terminals of two capacities, except the end terminals (A and B), and an $n^{th}$ transistor of the second group ($T_{2n}$) is connected between the other end terminal (B) and a reference voltage ($V_R$), permitting the regulation of the offset voltage of the multiplier which thus becomes differential.

6. A filter according to claim 5, characterized in that it comprises two integrated capacities which are to be switched and which show the same value and present the same parasite capacities ($C_{P1}$ and $C_{P2}$) with respect to their terminals ($B_1$ and $B_2$), the parasite capacities of the two terminals being different, characterized further in that a MOS transistor of the second group ($T_{21}$) is connected by its drain and source to the two terminals of both capacities which are to be switched and have the same parasite capacities, another MOS transistor ($T_{50}$) being connected by its drain and its source between one of the end terminals (A) and earth and being commanded by a signal ($\Phi_4$) which is applied to its grid and which permits the discharge of the parasite capacity of the capacity connected to that end terminal (A) during the time interval ($\tau$) comprised between the end of the switching into a parallel configuration and the switching of the capacities into a series configuration, the reference voltage ($V_R$) being the earth potential of the multiplier.

7. A filter according to one of the claims 4, 5 or 6, characterized in that a MOS transistor ($T_3$) is connected by its drain and its source between one of the end terminals (A) and a point (F), and characterized in that a capacity ($C_{20}$) is connected on the one hand to that point (F) and on the other hand to a voltage to which the other end terminal (B) is driven when the capacities are series connected, this MOS transistor ($T_3$) operating as a switch and being commanded by a periodical signal ($\Phi_3'$) which is applied to its grid, this transistor ($T_3$) being rendered conductive during the time interval when the capacities are switched into series configuration in order to allow the transfer of the amplified voltage from the end terminal (A) to said point (F) to which terminal and point this transistor is connected.

8. A filter according to claim 4, characterized in that a capacity ($C_{20}$) is connected between the end terminals (A and B).

9. A filter of the switched capacities type according to claim 2, characterized in that it comprises two periodically switched capacities ($C_1$, $C_2$), and that the gain of the multiplier is between 1 and 2.

10. A filter according to claim 9, characterized in that the multiplier of the switched capacities type comprises two switchable capacities ($C_1$ and $C_2$) which are merged with the last capacity of the filtering cell.

**Patentansprüche**

1. Filter zur Ladungsübertragung mit:
- einem Halbleitersubstrat,
- einer auf das Substrat aufgebrachten Isolierschicht,
- Elektroden ($EI_1$, $EI_2$), die auf die Isolierschicht aufgebracht sind und die durch Anwendung von vorgegebenen Potentialen ($\Phi_1$, $\Phi_2$) die Übertragung der Ladungen in dem Substrat bewirken,
- Mitteln zum Lesen ($M_1$, $M_2$) von Ladungsmengen,
- einem Differentialverstärker, der die von den Lesemitteln gelieferten Spannungen ($V_E^+$, $V_E^-$) zugeführt erhält und die Ausgangsspannung ($V_S$) des Filters erarbeitet,
dadurch gekennzeichnet, dass dieser Verstärker aus einem Spannungsmultiplizierer besteht, der n Kapazitäten ($C_1$ bis $C_n$) aufweist, die periodisch in Parallel- und in Serienschaltung von als Schalter wirkenden Transistoren des MOS-Typs ($T_{11}$ bis $T_{2n}$) umgeschaltet werden, wobei eine gemeinsame Spannung gleichzeitig die n parallelgeschalteten Kapazitäten lädt und wobei eine multiplizierte Spannung zwischen den Endklemmen (A und B) der n seriengeschalteten Kapazitäten erhalten wird, und dass die n Kapazitäten und die MOS- Transistoren auf dem gleichen Halbleitersubstrat integriert sind.

2. Filter mit geschalteten Kapazitäten, das mindestens eine Filterzelle aufweist, die aus Kapazitäten und MOS-Transistoren ($T_{60}$ bis $T_{63}$) besteht und einem Verstärker (7) zugeordnet ist, dadurch gekennzeichnet, dass dieser Verstärker aus einem Spannungsmultiplizierer besteht, der n periodisch von als Schalter wirkenden Transistoren vom MOS-Typ ($T_{11}$ bis $T_{2(n-1)}$) in Parallel- und in Serienschaltung umschaltbare Kapazitäten ($C_1$ bis $C_n$) enthält, wobei eine gemeinsame Spannung gleichzeitig die n parallelgeschalteten Kapazitäten lädt und eine multiplizierte Spannung zwischen den Endklemmen (A und B) der n seriengeschalteten Kapazitäten erhalten wird, und dass die n Kapazitäten und die MOS-Transistoren auf dem gleichen Halbleitersubstrat integriert sind.

3. Filter nach einem der Ansprüche 1 oder 2, dadurch gekennzeichnet, dass im Spannungsmultiplizierer eine erste Gruppe von Transistoren ($G_1$) die Parallelschaltung der n Kapazitäten und eine zweite Gruppe von Transistoren ($G_2$) die Serienschaltung dieser Kapazitäten bewirkt, und dass die Umschaltung dieser beiden Gruppen von Transistoren von zwei periodischen Signalen ($\Phi_1$ und $\Phi_2$) gesteuert wird, die an die Gitter der MOS-Transistoren angelegt werden, wobei diese Signale so sind, dass die beiden Gruppen von Transistoren nicht gleichzeitig leitend sind.

4. Filter nach den Ansprüchen 2 und 3, dadurch gekennzeichnet, dass n Transistoren der ersten Gruppe ($T_{11}$ bis $T_{1n}$) mit ihrem Drainanschluss und ihrem Quellenanschluss zwischen einer der Klemmen jeder Kapazität, von denen eine die Endklemme (A) ist, und dem Eingang (E) angeschlossen sind, an den eine Spannung ($V_E$) angelegt ist, während (n–1) andere Transistoren der ersten Gruppe ($T_1[n+1]$ bis $T_1[2n–1]$) mit ihren Drain- und ihren Quellenanschlüssen zwischen der anderen Klemme jeder Kapazität und Masse angeschlossen sind, mit Ausnahme der anderen Endklemme (B), die direkt mit der Masse verbunden ist, wobei (n–1) Transistoren der zweiten Gruppe ($T_{21}$ bis $T_2[n–1]$) mit ihren Drain- und ihren Quellenanschlüssen zwischen den Klemmen zweier Kapazitäten, mit Ausnahme der Endklemmen (A und B), angeschlossen sind.

5. Filter nach den Ansprüchen 1 und 3, dadurch gekennzeichnet, dass n Transistoren der ersten Gruppe ($T_{11}$ bis $T_{1n}$) mit ihren Drain- und Quellenanschlüssen zwischen einer der Klemmen jeder Kapazität, zu denen auch eine der Endklemmen (A) gehört, und einem Eingang ($E_1$) angeschlossen sind, an den eine Spannung ($V_E^+$) angelegt wird, während n weitere Transistoren der ersten Gruppe ($T_1[n+1]$ bis $T_1[2n]$) zwischen der anderen Klemme jeder Kapazität, zu denen auch die andere Endklemme (B) gehört, und einem zweiten Eingang ($E_2$) angeschlossen sind, an den eine andere Spannung ($V_E^-$) angelegt wird, wobei (n–1) Transistoren der zweiten Gruppe ($T_{21}$ bis $T_{2(n-1)}$) mit ihren Drain- und Quellenanschlüssen zwischen den Klemmen zweier Kapazitäten, mit Ausnahme der Endklemmen (A und B) eingefügt sind, und wobei ein n-ter Transistor der zweiten Gruppe ($T_{2n}$) zwischen der anderen Endklemme (B) und einer Bezugsspannung ($V_R$) angeschlossen ist, wodurch die Offset-Spannung des somit differentiellen Multiplizierers geregelt werden kann.

6. Filter nach Anspruch 5, dadurch gekennzeichnet, dass es zwei integrierte zu schaltende Kapazitäten gleichen Werts aufweist, die bezüglich ihrer Klemmen ($B_1$ und $B_2$) dieselben parasitären Kapazitäten ($C_{P1}$ und $C_{P2}$) besitzen, wobei jedoch die parasitären Kapazitäten der beiden Klemmen unterschiedlich sind, und dass ein MOS-Transistor der zweiten Gruppe ($T_{21}$) mit seinem Drain- und Quellenanschlüssen an die beiden dieselben parasitären Kapazitäten aufweisenden Klemmen der beiden umzuschaltenden Kapazitäten angeschlossen ist, während ein anderer MOS-Transistor ($T_{50}$) mit seinen Drain- und Quellenanschlüssen zwischen eine der Endklemmen (A) und Masse angeschlossen ist und von einem an seinen Gitteranschluss angelegten Signal ($\Phi_4$) gesteuert wird, das ihm erlaubt, die parasitäre Kapazität der an diese Endklemme (A) angeschlossenen Kapazität in einer Zeitspanne ($\tau$) zu entladen, die zwischen dem Ende der Parallelschaltung und der Serienschaltung der Kapazitäten liegt, wobei die Bezugsspannung ($V_R$) die Masse des Multiplizierers ist.

7. Filter nach einem der Ansprüche 4, 5 oder 6, dadurch gekennzeichnet, dass ein MOS-Transistor ($T_3$) mit seinen Drain- und Quellenanschlüssen zwischen einer der Endklemmen (A) und einem Punkt (F) angeschlossen ist, und dass eine Kapazität ($C_{20}$) einerseits an diesen Punkt (F) und anderseits an die Spannung angelegt ist, auf die die andere Endklemme (B) gebracht wird, wenn die Kapazitäten in Reihe geschaltet sind, wobei dieser MOS-Transistor ($T_3$) als Schalter betrieben wird und von einem an seinen Gitteranschluss angelegten periodischen Signal ($\Phi_3'$) gesteuert wird, und wobei dieser Transistor ($T_3$) während der Zeitspanne leitend gemacht wird, in der die Kapazitäten in Serie geschaltet sind, um die Übertragung der verstärkten Spannung von der Endklemme (A) an den genannten Punkt (F), mit denen dieser Transistor verbunden ist, zu ermöglichen.

8. Filter nach Anspruch 4, dadurch gekennzeichnet, dass eine Kapazität ($C_{20}$) zwischen den Endklemmen (A und B) angeschlossen ist.

9. Filter mit geschalteten Kapazitäten nach Anspruch 2, dadurch gekennzeichnet, dass es zwei periodisch umgeschaltete Kapazitäten ($C_1$, $C_2$) aufweist und dass der Verstärkungsgrad des Multiplizierers zwischen 1 und 2 liegt.

10. Filter nach Anspruch 9, dadurch gekennzeichnet, dass der Multiplizierer mittels Umschaltung von Kapazitäten zwei umzuschaltende Kapazitäten ($C_1$ und $C_2$) aufweist, die mit der letzten Kapazität der Filterzelle zusammenfallen.

FIG_1

FIG_2

FIG_2-a

FIG_2-b

FIG_2-c

FIG_2-d

FIG_3

FIG_4

FIG_4-a

FIG_4-b

FIG_5

FIG_6

FIG_6-a

FIG_6-b

FIG_7